# EUROPEAN PATENT APPLICATION

(11) **EP 4 625 818 A1**
(43) Date of publication of application: **01.10.2025**
(21) Application number: 23909957.5
(22) Date of filing: 04.12.2023
(51) Int. Cl.: H03K 17/00

(54) **GATING APPARATUS AND GATING METHOD**

(30) Priority: 29.12.2022 CN 202211726531
(71) Applicant: Huawei Technologies Co., Ltd., Shenzhen, Guangdong 518129 (CN)
(72) Inventor: WEI, Xiaodong, Shenzhen, Guangdong 518129 (CN); PU, Tao, Shenzhen, Guangdong 518129 (CN); XIAO, Weihong, Shenzhen, Guangdong 518129 (CN); HU, Peifeng, Shenzhen, Guangdong 518129 (CN); HE, Qiang, Shenzhen, Guangdong 518129 (CN)
(74) Representative: Pfenning, Meinig & Partner mbB
(86) International application number: PCT/CN2023/136046
(87) International publication number: WO 2024/140027

(57) **Abstract**

Embodiments of this application disclose a gating apparatus and a gating method, to implement a gating function in a simple structure and matching form. In this application, the gating apparatus includes four main branches, M loading branches, M radio frequency switches, and four ports. The M radio frequency switches are all grounded, and M is equal to 2 or 4. The four main branches are sequentially connected end to end, and one of the four ports is disposed at a junction of any two connected main branches in the four main branches. When M is equal to 4, each of the four main branches is connected to one of the four loading branches, and each loading branch is connected to one of the M radio frequency switches. When M is equal to 2, two unconnected main branches in the four main branches each are connected to one of the two loading branches, and each loading branch is connected to one of the two radio frequency switches.

## Description

This application claims priority to Chinese Patent Application No. 202211726531.X, filed with the China National Intellectual Property Administration on December 29, 2022 and entitled "GATING APPARATUS AND GATING METHOD", which is incorporated herein by reference in its entirety.

### TECHNICAL FIELD

This application relates to the field of communication technologies, and in particular, to a gating apparatus and a gating method.

### BACKGROUND

A switch is a common logical structure, and is mainly configured to control on/off or a transmission path of a signal. In some scenarios, a plurality of switches may be combined into a switch matrix by using a specific relationship, to implement different logical requirements. How to design a switch characterized by multi-function integration and fast switching is extremely important in development of communication technologies.

The switch may have a gating form such as single-pole single-throw, single-pole double-throw, or double-pole double-throw. A current double-pole double-throw switch usually includes an upper-layer microstrip structure, a loading capacitor, a switch control circuit, an intermediate dielectric substrate, and a bottom-layer metal floor. The upper-layer microstrip structure is a left-right symmetric structure, and includes 18 ports. A port 1 or a port 18 is used as receiving ends or transmitting ends, and signal paths formed from the port 1 or the port 18 to other 16 ports are of a same structure. In addition, the loading capacitor is disposed at a front end of a port, and is configured to isolate a direct current signal. In addition, the switch control circuit includes a loading switch diode, a square microstrip patch, a loading choke inductor, and a bias voltage.

In the foregoing technical solution, because of a complex structure, a matching form for implementing a gating function is also quite complex, costs are high, and it is difficult to implement large-scale application in a scenario of dual-channel gating in a small volume.

### SUMMARY

Embodiments of this application provide a gating apparatus and a gating method, to implement a gating function in a simple structure and matching form.

A first aspect of this application provides a gating apparatus, including four main branches, M loading branches, M radio frequency switches, and four ports. The M radio frequency switches are all grounded, and M is equal to 2 or 4. The four main branches are sequentially connected end to end, and one of the four ports is disposed at a junction of any two connected main branches in the four main branches. When M is equal to 4, each of the four main branches is connected to one of the four loading branches, and each loading branch is connected to one of the M radio frequency switches. When M is equal to 2, two unconnected main branches in the four main branches each are connected to one of the two loading branches, and each loading branch is connected to one of the two radio frequency switches. Therefore, two radio frequency switches corresponding to two unconnected main branches in the four main branches may be turned on, and other radio frequency switches in the M radio frequency switches may be turned off; the M radio frequency switches may be turned on; or the M radio frequency switches may be turned off, to implement a gating function. Because of a simple structure, a matching form for implementing the gating function is also simple, costs are low, and it is easy to implement large-scale application in a scenario of dual-channel gating in a small volume.

In some possible implementations, when M is equal to 4, the four main branches each are a transmission line whose equivalent electrical length is a 1/2 wavelength. In this case, two radio frequency switches corresponding to two unconnected main branches in the four main branches may be turned on, and other radio frequency switches in the M radio frequency switches may be turned off, so that the gating apparatus can implement a double-pole double-throw function.

In some possible implementations, the four main branches each are a transmission line whose equivalent electrical length is a 1/4 wavelength, and the four loading branches each are a transmission line whose equivalent electrical length is a 1/4 wavelength. In this case, two radio frequency switches corresponding to two unconnected main branches in the four main branches may be turned on, and other radio frequency switches in the M radio frequency switches may be turned off, so that the gating apparatus can implement a double-pole double-throw function. Alternatively, the M radio frequency switches may be turned on, so that the gating apparatus can implement a function of a bridge.

In some possible implementations, the M loading branches each are a transmission line whose equivalent electrical length is a 1/4 wavelength. In this case, a corresponding radio frequency switch may be turned on, to connect a corresponding main branch.

In some possible implementations, the M loading branches each are a transmission line whose equivalent electrical length is a 1/2 wavelength. In this case, a corresponding radio frequency switch may be turned on, to disconnect a corresponding main branch.

In some possible implementations, at least one of the four loading branches is disposed on an outer side of a ring formed by the four main branches, so that the M radio frequency switches are easily controlled.

In some possible implementations, at least one of the four loading branches is disposed on an inner side of a ring formed by the four main branches, so that the gating apparatus has a smaller volume.

In some possible implementations, any one of the M radio frequency switches is a metal-oxide-semiconductor field-effect transistor MOSFET, a diode, a micro-electro-mechanical system MEMS, or a reed switch, so that on/off of the M radio frequency switches can be controlled.

A second aspect of this application provides a gating method, applied to the gating apparatus according to any one of claims 1 to 8. When M is equal to 4, the method includes:
turning on two radio frequency switches corresponding to two unconnected main branches in the four main branches, and turning off other radio frequency switches in the M radio frequency switches; turning on the M radio frequency switches; or turning off the M radio frequency switches. Therefore, a gating function is implemented. Because of a simple structure, a matching form for implementing the gating function is also simple, costs are low, and it is easy to implement large-scale application in a scenario of dual-channel gating in a small volume.

In some possible implementations, when M is equal to 2, the method further includes: turning on the M radio frequency switches; or turning off the M radio frequency switches. Therefore, a function of a bridge of the gating apparatus can be implemented.

### BRIEF DESCRIPTION OF DRAWINGS

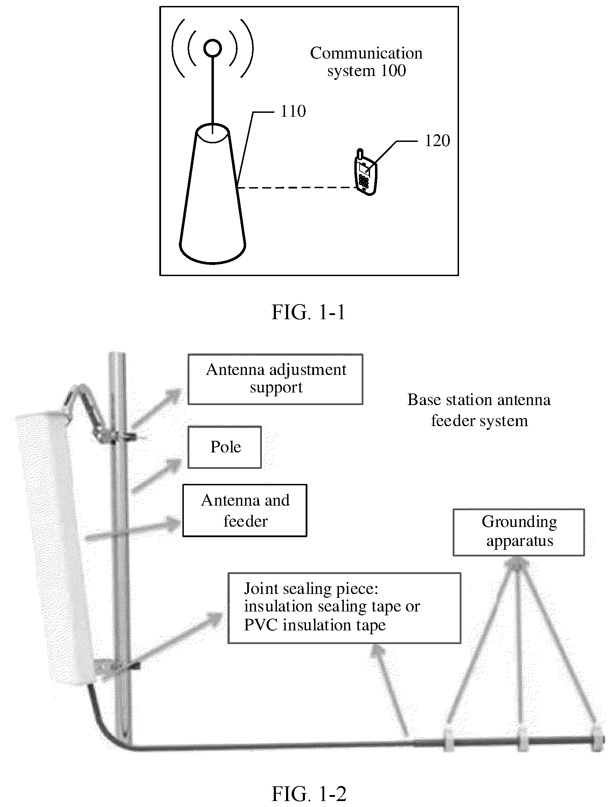

FIG. 1-1 is a diagram of a composition structure of a communication system according to an embodiment of this application;
FIG. 1-2 is a diagram of a composition structure of a base station antenna feeder system according to an embodiment of this application;
FIG. 2-1 is a diagram of a composition structure of a gating apparatus according to an embodiment of this application;
FIG. 2-2 is a diagram of another composition structure of a gating apparatus according to an embodiment of this application;

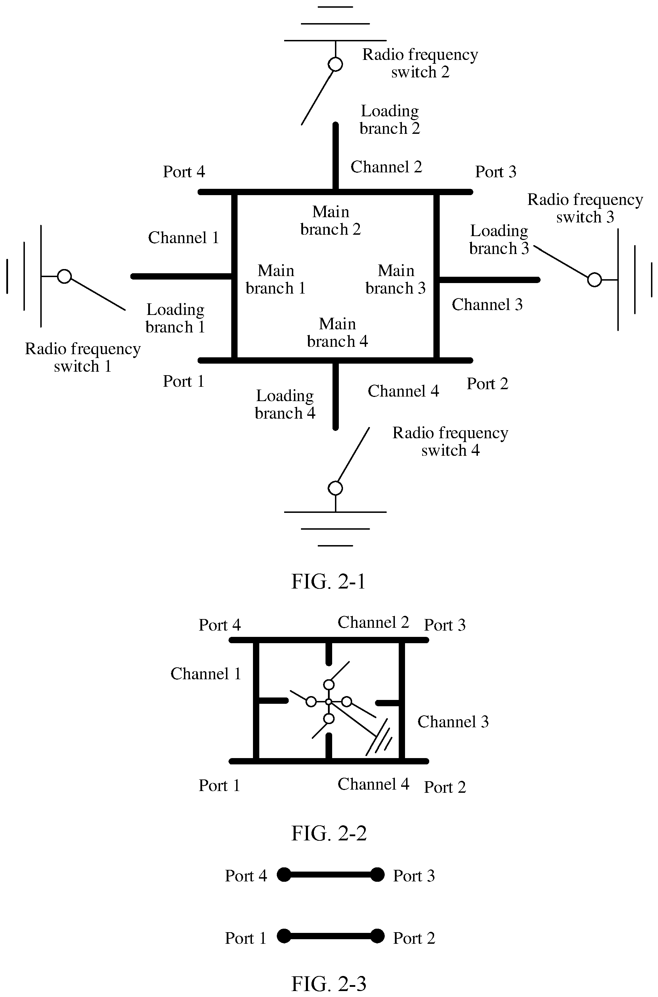

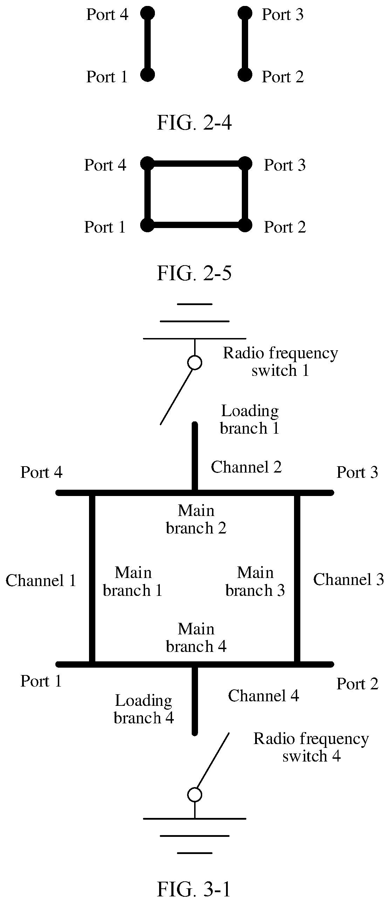

FIG. 2-3 is a diagram of a logical channel state of a gating apparatus according to an embodiment of this application;
FIG. 2-4 is a diagram of another logical channel state of a gating apparatus according to an embodiment of this application;
FIG. 2-5 is a diagram of another logical channel state of a gating apparatus according to an embodiment of this application;
FIG. 3-1 is a diagram of a composition structure of a gating apparatus according to an embodiment of this application; and

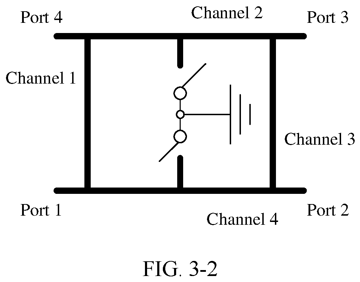

FIG. 3-2 is a diagram of another composition structure of a gating apparatus according to an embodiment of this application.

### DESCRIPTION OF EMBODIMENTS

Embodiments of this application provide a gating apparatus and a gating method, to implement a gating function in a simple structure and matching form.

The following describes embodiments of this application with reference to the accompanying drawings. It is clear that the described embodiments are merely some rather than all of embodiments of this application. A person of ordinary skill in the art may learn that, with development of technologies and emergence of new scenarios, the technical solutions provided in embodiments of this application are also used in a similar technical problem.

In the specification, claims, and accompanying drawings of this application, the terms such as "first" and "second" are intended to distinguish between similar objects but are not necessarily intended to describe a specific order or sequence. It should be understood that the data termed in such a way is interchangeable in proper circumstances so that embodiments described herein can be implemented in an order other than that in the content illustrated or described herein. Moreover, the terms "include", "have", and any other variants thereof are intended to cover non-exclusive inclusion. For example, a process, method, system, product, or device that includes a list of steps or modules is not necessarily limited to those steps or modules expressly listed, but may include other steps or modules not expressly listed or inherent to such a process, method, product, or device. Names or numbers of steps in this application do not mean that the steps in the method procedure need to be performed in a time/logical sequence indicated by the names or numbers. An execution sequence of the steps in the procedure that have been named or numbered can be changed based on a technical objective to be achieved, provided that same or similar technical effects can be achieved.

FIG. 1-1 is a diagram of a composition structure of a communication system according to an embodiment of this application. This embodiment of this application provides a communication system 100, including a base station 110 and a terminal device 120.

The communication system 100 may be a long term evolution (long term evolution, LTE) system, a 5th generation (5th generation, 5G) communication system, or another similar communication system. In addition, the communication system 100 may be further used in a future-oriented communication technology, and is used in all the technical solutions provided in embodiments of this application. A system architecture and a service scenario described in embodiments of this application are intended to describe the technical solutions in embodiments of this application more clearly, and do not constitute a limitation on the technical solutions provided in embodiments of this application. A person skilled in the art may learn that, with evolution of network architectures and emergence of new service scenarios, the technical solutions provided in embodiments of this application are also used in a similar technical problem.

The terminal device 120 is a device used by a user, may also be referred to as user equipment (user equipment, UE), and is a device having a wireless transceiver function. The device may be deployed on land, including indoor or outdoor, wearable, handheld, or vehicle-mounted devices, may be deployed on water (for example, on a steamship), or may be deployed in the air (for example, on an airplane, a balloon, or a satellite). The terminal device may be a mobile phone (mobile phone), a tablet computer (pad), a computer having a wireless transceiver function, a virtual reality (virtual reality, VR) terminal, an augmented reality (augmented reality, AR) terminal, a wireless terminal in industrial control (industrial control), a wireless terminal in self driving (self driving), a wireless terminal in a remote medical (remote medical), a wireless terminal in a smart grid (smart grid), a wireless terminal in transportation safety (transportation safety), a wireless terminal in a smart city (smart city), a wireless terminal in a smart home (smart home), a wireless terminal in an internet of things (internet of things, IoT), or the like.

The base station 110 is an access device through which the terminal device 120 accesses a mobile communication system in a wireless manner, for example, an evolved NodeB (evolved NodeB, eNB), a transmission reception point (transmission reception point, TRP), a next generation NodeB (next generation NodeB, gNB) in a 5G mobile communication system, a base station in a future mobile communication system, or an access node in a WiFi system. A specific technology and a specific device form that are used by the network device are not limited in embodiments of this application.

In this embodiment of this application, the base station 110 may include a base station antenna feeder system, a remote radio unit (remote radio unit, RRU), and a baseband processing unit (baseband unit, BBU). An antenna feeding network is connected to the RRU, and the RRU is connected to the BBU (through, for example, an optical fiber). As shown in FIG. 1-2, the base station antenna feeder system may include an antenna, a feeder, a pole, an antenna adjustment support, a joint sealing piece (insulation sealing tape or polyvinyl chloride (polyvinyl chloride, PVC) insulation tape), a grounding apparatus, and the like.

A switch is a common logical structure, and is mainly configured to control on/off or a transmission path of a signal. In some scenarios, a plurality of switches may be combined into a switch matrix by using a specific relationship, to implement different logical requirements. How to design a switch characterized by multi-function integration and fast switching is extremely important in development of communication technologies.

The switch may have a gating form such as single-pole single-throw, single-pole double-throw, or double-pole double-throw. A current double-pole double-throw switch usually includes an upper-layer microstrip structure, a loading capacitor, a switch control circuit, an intermediate dielectric substrate, and a bottom-layer metal floor. The upper-layer microstrip structure is a left-right symmetric structure, and includes 18 ports. A port 1 or a port 18 is used as receiving ends or transmitting ends, and signal paths formed from the port 1 or the port 18 to other 16 ports are of a same structure. In addition, the loading capacitor is disposed at a front end of a port, and is configured to isolate a direct current signal. In addition, the switch control circuit includes a loading switch diode, a square microstrip patch, a loading choke inductor, and a bias voltage.

In the foregoing technical solution, because of a complex structure, a matching form for implementing a gating function is also quite complex, costs are high, and it is difficult to implement large-scale application in a scenario of dual-channel gating in a small volume.

In view of this, this application provides a gating apparatus and a gating method, to implement a gating function in a simple structure and matching form.

In this application, the gating apparatus includes four main branches, M loading branches, M radio frequency switches, and four ports. The M radio frequency switches are all grounded, and M is equal to 2 or 4. The four main branches are sequentially connected end to end, and one of the four ports is disposed at a junction of any two connected main branches in the four main branches.

In this case, when M is equal to 4, each of the four main branches is connected to one of the four loading branches, and each loading branch is connected to one of the M radio frequency switches. Therefore, two radio frequency switches corresponding to two unconnected main branches in the four main branches may be turned on, and other radio frequency switches in the M radio frequency switches may be turned off; the M radio frequency switches may be turned on; or the M radio frequency switches may be turned off, to implement a gating function.

When M is equal to 2, two unconnected main branches in the four main branches each are connected to one of the two loading branches, and each loading branch is connected to one of the M radio frequency switches. Therefore, the M radio frequency switches may be turned on; or the M radio frequency switches may be turned off, to implement a gating function.

Because of a simple structure, a matching form for implementing the gating function is also simple, costs are low, and it is easy to implement large-scale application in a scenario of dual-channel gating in a small volume.

The following separately provides descriptions by using a plurality of embodiments.

### Embodiment 1

In this embodiment of this application, as shown in FIG. 2-1, a gating apparatus includes four main branches, four loading branches, M radio frequency switches, and four ports. The four main branches are respectively a main branch 1, a main branch 2, a main branch 3, and a main branch 4 that are sequentially connected end to end. The four loading branches are respectively a loading branch 1, a loading branch 2, a loading branch 3, and a loading branch 4. The four ports are respectively a port 1, a port 2, a port 3, and a port 4.

The loading branch 1 is loaded on the main branch 1, the loading branch 2 is loaded on the main branch 2, the loading branch 3 is loaded on the main branch 3, and the loading branch 4 is loaded on the main branch 4. The port 4 is disposed at an end at which the main branch 1 and the main branch 2 intersect, the port 3 is disposed at an end at which the main branch 2 and the main branch 3 intersect, the port 2 is disposed at an end at which the main branch 3 and the main branch 4 intersect, and the port 1 is disposed at an end at which the main branch 1 and the main branch 4 intersect. In this case, a channel 2 is formed between the port 4 and the port 3, a channel 3 is formed between the port 3 and the port 2, a channel 4 is formed between the port 2 and the port 1, and a channel 1 is formed between the port 1 and the port 4.

In some possible implementations, as shown in FIG. 2-1, the loading branches 1 to 4 may be separately disposed on an outer side of a ring formed by the main branches 1 to 4. In some possible implementations, to save space, as shown in FIG. 2-2, alternatively, the loading branches 1 to 4 may be separately disposed on an inner side of a ring formed by the main branches 1 to 4. In some possible implementations, alternatively, one part of the loading branches 1 to 4 may be disposed on an inner side of a ring formed by the main branches 1 to 4, and the other part of the loading branches 1 to 4 may be disposed on an outer side of the ring formed by the main branches 1 to 4. This is not limited herein.

In some feasible implementations, the radio frequency switches 1 to 4 are switches that implement on/off by receiving a control signal, and may be metal-oxide-semiconductor field-effect transistors (metal-oxide-semiconductor field-effect transistor, MOSFET), or may be other components with similar functions, such as diodes, micro-electro-mechanical systems (micro-electro-mechanical system, MEMS), or reed tubes, provided that on/off of the switches can be controlled by sending a control signal. This is not limited herein. The radio frequency switches 1 to 4 are all grounded. States of the radio frequency switches 1 to 4 may be off or on. The states of the radio frequency switches 1 to 4 may be used to control whether the loading branches 1 to 4 are open circuits or short circuits, to control disconnection or connection of the channels 1 to 4.

It should be noted that, when the loading branches 1 to 4 each are a transmission line whose equivalent electrical length is a 1/4 wavelength, a corresponding radio frequency switch is turned off, to form an open-circuit loading branch. This can play a filtering function, to filter a channel signal of a corresponding channel, so that the entire channel is disconnected. Alternatively, a corresponding radio frequency switch is turned on, to form a short-circuit loading branch. This has no impact on a channel signal of a corresponding channel, so that the channel is connected. Correspondingly, when the loading branches 1 to 4 each are a transmission line whose equivalent electrical length is a 1/2 wavelength, a corresponding radio frequency switch is turned off, to form an open-circuit loading branch. This has no impact on a channel signal of a corresponding channel, so that the channel is connected. Alternatively, a corresponding radio frequency switch is turned on, to form a short-circuit loading branch. This can play a filtering function, to filter a channel signal of a corresponding channel, so that the entire channel is disconnected. Therefore, in this embodiment of this application, a state of the gating apparatus may be controlled in the following manners by using the radio frequency switches 1 to 4.

The following separately describes cases in which the loading branches 1 to 4 and the main branches 1 to 4 are transmission lines of different equivalent electrical lengths.

### Implementation 1

In some feasible implementations, the main branches 1 to 4 each are a transmission line whose equivalent electrical length is a 1/2 wavelength, and the loading branches 1 to 4 each are a transmission line whose equivalent electrical length is a 1/4 wavelength. As described above, a formed short-circuit loading branch whose equivalent electrical length is a 1/4 wavelength has no impact on a channel signal of a corresponding channel, so that the channel is connected; and a formed open-circuit loading branch whose equivalent electrical length is a 1/4 wavelength can play a filtering function, to filter a channel signal of a corresponding channel, so that the entire channel is disconnected.

Therefore, when the radio frequency switch 2 and the radio frequency switch 4 are controlled to be turned on, and the radio frequency switch 1 and the radio frequency switch 3 are controlled to be turned off, the channel 1 and the channel 3 are disconnected, and the channel 2 and the channel 4 are connected, in other words, the port 4 is connected to the port 3, the port 1 is connected to the port 2, the port 4 is disconnected from the port 1, and the port 2 is disconnected from the port 3, to implement a logical channel state 1 shown in FIG. 2-3.

When the radio frequency switch 2 and the radio frequency switch 4 are controlled to be turned off, and the radio frequency switch 1 and the radio frequency switch 3 are controlled to be turned on, the channel 1 and the channel 3 are connected, and the channel 2 and the channel 4 are disconnected, in other words, the port 4 is disconnected from the port 3, the port 1 is disconnected from the port 2, the port 4 is connected to the port 1, and the port 2 is connected to the port 3, to implement a logical channel state 2 shown in FIG. 2-4.

Therefore, it can be learned that, on/off of different radio frequency switches in the gating apparatus may be controlled, to control the gating apparatus to implement the logical channel state 1 or the logical channel state 2, thereby implementing a double-pole double-throw gating function. In addition, a matching form of the gating function is quite simple, costs are low, and it is easy to implement large-scale application in a scenario of dual-channel gating in a small volume.

In some possible implementations, the loading branches 1 to 4 may alternatively be transmission lines whose equivalent electrical lengths are other wavelengths, so that the gating apparatus implements conversion between the logical channel state 1 and the logical channel state 2. This is not limited herein. For example, refer to Implementation 2.

### Implementation 2

In some feasible implementations, the main branches 1 to 4 each are a transmission line whose equivalent electrical length is a 1/2 wavelength, and the loading branches 1 to 4 each are a transmission line whose equivalent electrical length is a 1/2 wavelength. As described above, a formed open-circuit loading branch whose equivalent electrical length is a 1/2 wavelength has no impact on a channel signal of a corresponding channel, so that the channel is connected; and a formed short-circuit loading branch whose equivalent electrical length is a 1/2 wavelength can play a filtering function, to filter a channel signal of a corresponding channel, so that the entire channel is disconnected.

Therefore, when the radio frequency switch 2 and the radio frequency switch 4 are controlled to be turned off, and the radio frequency switch 1 and the radio frequency switch 3 are controlled to be turned on, the channel 1 and the channel 3 are disconnected, and the channel 2 and the channel 4 are connected, in other words, the port 4 is connected to the port 3, the port 1 is connected to the port 2, the port 4 is disconnected from the port 1, and the port 2 is disconnected from the port 3, to implement a logical channel state 1 shown in FIG. 2-3.

When the radio frequency switch 2 and the radio frequency switch 4 are controlled to be turned on, and the radio frequency switch 1 and the radio frequency switch 3 are controlled to be turned off, the channel 1 and the channel 3 are connected, and the channel 2 and the channel 4 are disconnected, in other words, the port 4 is disconnected from the port 3, the port 1 is disconnected from the port 2, the port 4 is connected to the port 1, and the port 2 is connected to the port 3, to implement a logical channel state 2 shown in FIG. 2-4.

Therefore, it can be learned that, on/off of different radio frequency switches in the gating apparatus may be controlled, to control the gating apparatus to implement the logical channel state 1 or the logical channel state 2, thereby implementing a double-pole double-throw gating function. In addition, a matching form of the gating function is quite simple, costs are low, and it is easy to implement large-scale application in a scenario of dual-channel gating in a small volume.

In some possible implementations, the main branches 1 to 4 may alternatively be transmission lines whose equivalent electrical lengths are other wavelengths, so that the gating apparatus implements conversion between the logical channel state 1 and the logical channel state 2. This is not limited herein. For example, refer to Implementation 3.

### Implementation 3

In some feasible implementations, the main branches 1 to 4 each are a transmission line whose equivalent electrical length is a 1/4 wavelength, and the loading branches 1 to 4 each are a transmission line whose equivalent electrical length is a 1/4 wavelength. As described above, a formed short-circuit loading branch whose equivalent electrical length is a 1/4 wavelength has no impact on a channel signal of a corresponding channel, so that the channel is connected; and a formed open-circuit loading branch whose equivalent electrical length is a 1/4 wavelength can play a filtering function, to filter a channel signal of a corresponding channel, so that the entire channel is disconnected.

Therefore, when the radio frequency switch 2 and the radio frequency switch 4 are controlled to be turned on, and the radio frequency switch 1 and the radio frequency switch 3 are controlled to be turned off, the channel 1 and the channel 3 are disconnected, and the channel 2 and the channel 4 are connected, in other words, the port 4 is connected to the port 3, the port 1 is connected to the port 2, the port 4 is disconnected from the port 1, and the port 2 is disconnected from the port 3, to implement a logical channel state 1 shown in FIG. 2-3.

When the radio frequency switch 2 and the radio frequency switch 4 are controlled to be turned off, and the radio frequency switch 1 and the radio frequency switch 3 are controlled to be turned on, the channel 1 and the channel 3 are connected, and the channel 2 and the channel 4 are disconnected, in other words, the port 4 is disconnected from the port 3, the port 1 is disconnected from the port 2, the port 4 is connected to the port 1, and the port 2 is connected to the port 3, to implement a logical channel state 2 shown in FIG. 2-4.

When the radio frequency switches 1 to 4 are controlled to be all turned on, the channels 1 to 4 are all connected, so that the gating apparatus forms a bridge, to implement a logical channel state 3 shown in FIG. 2-5.

Therefore, it can be learned that, on or off of different radio frequency switches in the gating apparatus may be controlled, to control the gating apparatus to implement the logical channel state 1, the logical channel state 2, or the logical channel state 3, thereby implementing a double-pole double-throw gating function. In addition, a matching form of the gating function is quite simple, costs are low, and it is easy to implement large-scale application in a scenario of dual-channel gating in a small volume. In addition, in a case of the logical channel state 3, the gating apparatus can implement a function of a bridge.

In some possible implementations, the loading branches 1 to 4 may alternatively be transmission lines whose equivalent electrical lengths are other wavelengths, so that the gating apparatus implements conversion between the logical channel state 1 and the logical channel state 2. This is not limited herein. For example, refer to Implementation 4.

### Implementation 4

In some feasible implementations, the main branches 1 to 4 each are a transmission line whose equivalent electrical length is a 1/4 wavelength, and the loading branches 1 to 4 each are a transmission line whose equivalent electrical length is a 1/2 wavelength. As described above, a formed open-circuit loading branch whose equivalent electrical length is a 1/2 wavelength has no impact on a channel signal of a corresponding channel, so that the channel is connected; and a formed short-circuit loading branch whose equivalent electrical length is a 1/2 wavelength can play a filtering function, to filter a channel signal of a corresponding channel, so that the entire channel is disconnected.

Therefore, when the radio frequency switch 2 and the radio frequency switch 4 are controlled to be turned off, and the radio frequency switch 1 and the radio frequency switch 3 are controlled to be turned on, the channel 1 and the channel 3 are disconnected, and the channel 2 and the channel 4 are connected, in other words, the port 4 is connected to the port 3, the port 1 is connected to the port 2, the port 4 is disconnected from the port 1, and the port 2 is disconnected from the port 3, to implement a logical channel state 1 shown in FIG. 2-3.

When the radio frequency switch 2 and the radio frequency switch 4 are controlled to be turned on, and the radio frequency switch 1 and the radio frequency switch 3 are controlled to be turned off, the channel 1 and the channel 3 are connected, and the channel 2 and the channel 4 are disconnected, in other words, the port 4 is disconnected from the port 3, the port 1 is disconnected from the port 2, the port 4 is connected to the port 1, and the port 2 is connected to the port 3, to implement a logical channel state 2 shown in FIG. 2-4.

When the radio frequency switches 1 to 4 are controlled to be all turned off, the channels 1 to 4 are all connected, so that the gating apparatus forms a bridge, to implement a logical channel state 3 shown in FIG. 2-5.

Therefore, it can be learned that, on/off of different radio frequency switches in the gating apparatus may be controlled, to control the gating apparatus to implement the logical channel state 1, the logical channel state 2, or the logical channel state 3, thereby implementing a double-pole double-throw gating function. In addition, a matching form of the gating function is quite simple, costs are low, and it is easy to implement large-scale application in a scenario of dual-channel gating in a small volume. In addition, in a case of the logical channel state 3, the gating apparatus can implement a function of a bridge.

In some possible implementations, the gating apparatus may include four loading branches as shown in Embodiment 1, or may include two loading branches. For example, refer to the following Embodiment 2.

### Embodiment 2

In this embodiment of this application, as shown in FIG. 3-1, a gating apparatus includes four main branches, two loading branches, two radio frequency switches, and four ports. The four main branches are respectively a main branch 1, a main branch 2, a main branch 3, and a main branch 4 that are sequentially connected end to end. The two loading branches are respectively a loading branch 1 and a loading branch 4. The four ports are respectively a port 1, a port 2, a port 3, and a port 4.

The loading branch 1 is loaded on the main branch 2, and the loading branch 4 is loaded on the main branch 4. The port 4 is disposed at an end at which the main branch 1 and the main branch 2 intersect, the port 3 is disposed at an end at which the main branch 2 and the main branch 3 intersect, the port 2 is disposed at an end at which the main branch 3 and the main branch 4 intersect, and the port 1 is disposed at an end at which the main branch 1 and the main branch 4 intersect. In this case, a channel 2 is formed between the port 4 and the port 3, a channel 3 is formed between the port 3 and the port 2, a channel 4 is formed between the port 2 and the port 1, and a channel 1 is formed between the port 1 and the port 4.

In some possible implementations, as shown in FIG. 3-1, the loading branches 1 and 2 may be separately disposed on an outer side of a ring formed by the main branches 1 to 4. In some possible implementations, to save space, as shown in FIG. 3-2, alternatively, the loading branches 1 and 2 may be separately disposed on an inner side of a ring formed by the main branches 1 to 4. In some possible implementations, alternatively, one part of the loading branches 1 and 2 may be disposed on an inner side of a ring formed by the main branches 1 to 4, and the other part of the loading branches 1 and 2 may be disposed on an outer side of the ring formed by the main branches 1 to 4. This is not limited herein.

In some feasible implementations, the radio frequency switches 1 and 2 are switches that implement on/off by receiving a control signal, and may be metal-oxide-semiconductor field-effect transistors (metal-oxide-semiconductor field-effect transistor, MOSFET), or may be other components with similar functions, such as diodes, micro-electro-mechanical systems (micro-electro-mechanical system, MEMS), or reed tubes, provided that on/off of the switches can be controlled by sending a control signal. This is not limited herein. The radio frequency switches 1 and 2 are both grounded. States of the radio frequency switches 1 and 2 may be off or on. The states of the radio frequency switches 1 and 2 may be used to control whether the loading branches 1 and 2 are open circuits or short circuits, to control disconnection or connection of the channel 2 and the channel 4.

It should be noted that, when the loading branches 1 and 2 each are a transmission line whose equivalent electrical length is a 1/4 wavelength, a corresponding radio frequency switch is turned off, to form an open-circuit loading branch. This can play a filtering function, to filter a channel signal of a corresponding channel, so that the entire channel is disconnected. Alternatively, a corresponding radio frequency switch is turned on, to form a short-circuit loading branch. This has no impact on a channel signal of a corresponding channel, so that the channel is connected. Correspondingly, when the loading branches 1 and 2 each are a transmission line whose equivalent electrical length is a 1/2 wavelength, a corresponding radio frequency switch is turned off, to form an open-circuit loading branch. This has no impact on a channel signal of a corresponding channel, so that the channel is connected. Alternatively, a corresponding radio frequency switch is turned on, to form a short-circuit loading branch. This can play a filtering function, to filter a channel signal of a corresponding channel, so that the entire channel is disconnected. Therefore, in this embodiment of this application, a state of the gating apparatus may be controlled in the following manners by using the radio frequency switches 1 and 2.

### Implementation 1

In some feasible implementations, the main branches 1 to 4 each are a transmission line whose equivalent electrical length is a 1/4 wavelength, and the loading branches 1 and 2 each are a transmission line whose equivalent electrical length is a 1/4 wavelength. As described above, a formed short-circuit loading branch whose equivalent electrical length is a 1/4 wavelength has no impact on a channel signal of a corresponding channel, so that the channel is connected; and a formed open-circuit loading branch whose equivalent electrical length is a 1/4 wavelength can play a filtering function, to filter a channel signal of a corresponding channel, so that the entire channel is disconnected.

Therefore, when the radio frequency switch 1 and the radio frequency switch 4 are controlled to be turned off, the channel 2 and the channel 4 are disconnected, and the channel 1 and the channel 3 are connected, in other words, the port 4 is disconnected from the port 3, the port 1 is disconnected from the port 2, the port 4 is connected to the port 1, and the port 2 is connected to the port 3, to implement a logical channel state 2 shown in FIG. 2-4.

When the radio frequency switch 1 and the radio frequency switch 4 are controlled to be turned on, the channels 1 to 4 are all connected, in other words, the ports 1 to 4 are all connected, to implement a logical channel state 3 shown in FIG. 2-5.

Therefore, it can be learned that, on/off of different radio frequency switches in the gating apparatus may be controlled, to control the gating apparatus to implement the logical channel state 1 or the logical channel state 3, thereby implementing a double-pole double-throw gating function. In addition, a matching form of the gating function is quite simple, costs are low, and it is easy to implement large-scale application in a scenario of dual-channel gating in a small volume. In addition, in a case of the logical channel state 3, the gating apparatus can implement a function of a bridge.

### Implementation 2

In some feasible implementations, the main branches 1 to 4 each are a transmission line whose equivalent electrical length is a 1/4 wavelength, and the loading branches 1 and 2 each are a transmission line whose equivalent electrical length is a 1/2 wavelength. As described above, a formed open-circuit loading branch whose equivalent electrical length is a 1/2 wavelength has no impact on a channel signal of a corresponding channel, so that the channel is connected; and a formed short-circuit loading branch whose equivalent electrical length is a 1/2 wavelength can play a filtering function, to filter a channel signal of a corresponding channel, so that the entire channel is disconnected.

Therefore, when the radio frequency switch 1 and the radio frequency switch 4 are controlled to be turned on, the channel 2 and the channel 4 are disconnected, and the channel 1 and the channel 3 are connected, in other words, the port 4 is disconnected from the port 3, the port 1 is disconnected from the port 2, the port 4 is connected to the port 1, and the port 2 is connected to the port 3, to implement a logical channel state 2 shown in FIG. 2-4.

When the radio frequency switch 1 and the radio frequency switch 4 are controlled to be turned off, the channels 1 to 4 are all connected, in other words, the ports 1 to 4 are all connected, to implement a logical channel state 3 shown in FIG. 2-5.

Therefore, it can be learned that, on/off of different radio frequency switches in the gating apparatus may be controlled, to control the gating apparatus to implement the logical channel state 1 or the logical channel state 3, thereby implementing a double-pole double-throw gating function. In addition, a matching form of the gating function is quite simple, costs are low, and it is easy to implement large-scale application in a scenario of dual-channel gating in a small volume. In addition, in a case of the logical channel state 3, the gating apparatus can implement a function of a bridge.

An embodiment of this application further provides a gating method, applied to the foregoing gating apparatus. When M is equal to 4, the method mainly includes:
turning on two radio frequency switches corresponding to two unconnected main branches in the four main branches, and turning off other radio frequency switches in the M radio frequency switches; turning on the M radio frequency switches; or turning off the M radio frequency switches. Therefore, a gating function is implemented. Because of a simple structure, a matching form for implementing the gating function is also simple, costs are low, and it is easy to implement large-scale application in a scenario of dual-channel gating in a small volume.

In some possible implementations, when M is equal to 2, the method further includes: turning on the M radio frequency switches; or turning off the M radio frequency switches. Therefore, a function of a bridge of the gating apparatus can be implemented.

In some possible implementations, the gating apparatus further includes a control chip, and the control chip is configured to control each phase shifter and each switch in the gating apparatus.

The control chip may include a processing unit and a communication unit. The processing unit may be, for example, a processor, and the communication unit may be, for example, an input/output interface, a pin, or a circuit. The processing unit may execute computer-executable instructions stored in a storage unit, to enable the chip in the terminal to perform the wireless report information sending method according to any one of the first aspect or the possible implementations of the first aspect. Optionally, the storage unit is a storage unit in the chip, for example, a register or a cache. Alternatively, the storage unit may be a storage unit that is in the terminal and that is located outside the chip, for example, a read-only memory (read-only memory, ROM) or another type of static storage device that may store static information and instructions, for example, a random access memory (random access memory, RAM).

The processor mentioned anywhere above may be a general-purpose central processing unit, a microprocessor, an ASIC, or one or more integrated circuits configured to control program execution of the foregoing method.

In addition, it should be noted that the foregoing described apparatus embodiment is merely an example. The units described as separate parts may or may not be physically separate, and parts displayed as units may or may not be physical units, to be specific, may be located in one place, or may be distributed on a plurality of network units. Some or all of the modules may be selected based on actual needs to achieve the objectives of the solutions of embodiments. In addition, in the accompanying drawings of the apparatus embodiments provided in this application, connection relationships between modules indicate that there are communication connections between the modules. This may be specifically implemented as one or more communication buses or signal cables.

Based on the foregoing descriptions of the implementations, a person skilled in the art may clearly understand that this application may be implemented by software and necessary universal hardware, or may be certainly implemented by dedicated hardware, including an application-specific integrated circuit, a dedicated CPU, a dedicated memory, a dedicated component, or the like. Generally, any function completed by a computer program can be easily implemented by corresponding hardware. Moreover, a specific hardware structure used to achieve a same function may be in various forms, for example, in a form of an analog circuit, a digital circuit, or a dedicated circuit. However, as for this application, software program implementation is a better implementation in most cases. Based on such an understanding, the technical solutions of this application essentially or the part contributing to the conventional technology may be implemented in a form of a software product. The computer software product is stored in a readable storage medium, such as a floppy disk, a USB flash drive, a removable hard disk, a ROM, a RAM, a magnetic disk, or an optical disc of a computer, and includes several instructions for instructing a computer device (which may be a personal computer, a server, a network device, or the like) to perform the methods described in embodiments of this application.

All or some of the foregoing embodiments may be implemented by using software, hardware, firmware, or any combination thereof. When software is used to implement the foregoing embodiments, all or some of the foregoing embodiments may be implemented in a form of a computer program product.

The computer program product includes one or more computer instructions. When the computer program instructions are loaded and executed on a computer, all or some of the procedures or functions according to embodiments of this application are generated. The computer may be a general-purpose computer, a dedicated computer, a computer network, or another programmable apparatus. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (DSL)) or wireless (for example, infrared, radio, or microwave) manner. The computer-readable storage medium may be any usable medium accessible by a computer, or a data storage device, such as a server or a data center, integrating one or more usable media. The usable medium may be a magnetic medium (for example, a floppy disk, a hard disk, or a magnetic tape), an optical medium (for example, a DVD), a semiconductor medium (for example, a solid state disk (Solid State Disk, SSD)), or the like.

## Claims

1. A gating apparatus, comprising:
four main branches, M loading branches, M radio frequency switches, and four ports, wherein the M radio frequency switches are all grounded, and M is equal to 2 or 4;
the four main branches are sequentially connected end to end, and one of the four ports is disposed at a junction of any two connected main branches in the four main branches;
when M is equal to 4, each of the four main branches is connected to one of the four loading branches, and each loading branch is connected to one of the M radio frequency switches; and
when M is equal to 2, two unconnected main branches in the four main branches each are connected to one of the two loading branches, and each loading branch is connected to one of the M radio frequency switches.

2. The gating apparatus according to claim 1, wherein when M is equal to 4, the four main branches each are a transmission line whose equivalent electrical length is a 1/2 wavelength.

3. The gating apparatus according to claim 1, wherein the four main branches each are a transmission line whose equivalent electrical length is a 1/4 wavelength, and the four loading branches each are a transmission line whose equivalent electrical length is a 1/4 wavelength.

4. The gating apparatus according to claim 2 or 3, wherein the M loading branches each are a transmission line whose equivalent electrical length is a 1/4 wavelength.

5. The gating apparatus according to claim 2 or 3, wherein the M loading branches each are a transmission line whose equivalent electrical length is a 1/2 wavelength.

6. The gating apparatus according to any one of claims 1 to 5, wherein at least one of the four loading branches is disposed on an outer side of a ring formed by the four main branches.

7. The gating apparatus according to any one of claims 1 to 5, wherein at least one of the four loading branches is disposed on an inner side of a ring formed by the four main branches.

8. The gating apparatus according to any one of claims 1 to 7, wherein any one of the M radio frequency switches is a metal-oxide-semiconductor field-effect transistor MOSFET, a diode, a micro-electro-mechanical system MEMS, or a reed switch.

9. A gating method, applied to the gating apparatus according to any one of claims 1 to 8, wherein when M is equal to 4, the method comprises:
turning on two radio frequency switches corresponding to two unconnected main branches in the four main branches, and turning off other radio frequency switches in the M radio frequency switches;
turning on the M radio frequency switches; or
turning off the M radio frequency switches.

10. The method according to claim 9, wherein when M is equal to 2, the method further comprises:
turning on the M radio frequency switches; or
turning off the M radio frequency switches.
